# EUROPEAN PATENT APPLICATION

(11) **EP 1 248 295 A2**
(43) Date of publication of application: **09.10.2002**
(21) Application number: 02007769.9
(22) Date of filing: 05.04.2002
(51) Int. Cl.: H01L 23/48, H01L 25/065

(54) **Semiconductor element, connection structure thereof, semiconductor device using a plurality of such elements and processes for making the same**

(30) Priority: 06.04.2001 JP 2001109118
(71) Applicant: SHINKO ELECTRIC INDUSTRIES CO. LTD., Nagano-shi, Nagano 380-0921 (JP)
(72) Inventor: Murayama, Kei, c/o Shinko Electric Ind. Co, Ltd., Nagano-shi, Nagano 380-0921 (JP); Higashi, Mitsutoshi, c/o Shinko Elec. Ind. Co, Ltd, Nagano-shi, Nagano 380-0921 (JP)
(74) Representative: von Hellfeld, Axel, Dr. Dipl.-Phys.

(57) **Abstract**

A connection structure for a stacking semiconductor element capable of realizing a large capacity, a small size and thickness, and a high-speed response, is provided. Also, a semiconductor device formed by stacking the semiconductor elements is provided. In a semiconductor element having conductive bumps, a via-hole is formed to pass through the semiconductor element and reach the back surface of the conductive bump. On the inner surface of the via-hole, a conductive cover film (Au or Cu cover film) continuous to the conductive bump is formed via an insulation layer (SiO₂ layer), wherein the conductive bump of one semiconductor element abuts to the via-hole of the other semiconductor element to establish a connection between the semiconductor elements.

## Description

### BACKGROUND OF THE INVENTION

### 1. Field of the Invention

The present invention relates to a structure of a semiconductor element, a connection structure thereof and a semiconductor device formed by stacking such semiconductor elements. The present invention also relates to processes for making such semiconductor element and devices.

### 2. Description of the Related Art

Various packages have been known, in the prior art, for carrying semiconductor elements (semiconductor chips such as LSI). Of them, TCP (a tape carrier package) is widely used nowadays because it is suitable for a multi-pin structure having small-pitched connector terminals so that the reduction of a total device thickness and size could be realized as well as it is advantageous in view of the economical standpoint and the productivity.

In general, a large capacity semiconductor device has been contemplated by stacking such semiconductor elements represented by TCP. In this case, since the semiconductor device should be small and thin, a connection structure is required which is capable of stacking as many as possible of the semiconductor elements in a predetermined height.

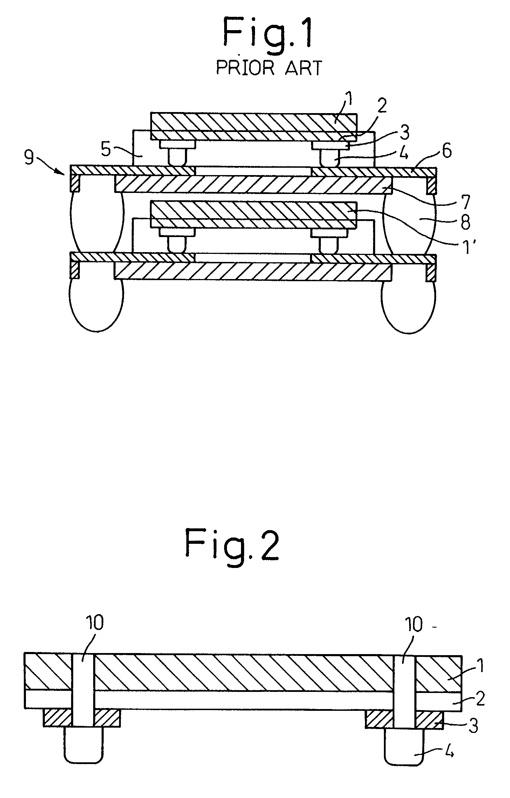

Fig. 1 shows a conventional connection structure for a prior art stacking type semiconductor device. A semiconductor element 1 has Al pads 3 on a circuitry surface 2. On each of the Al pad, an Au bump 4 is formed for the electric connection with other semiconductor element 1'. This semiconductor element is integral with an interposer 9 consisting of a circuit layer 6, an insulation layer 7 and solder bumps 8 via an underfil layer 5 made of a resin (such as epoxy resin) to complete a stacking semiconductor device. Since this stacking semiconductor device is of a structure for connecting the Au bump 4 of the semiconductor element 1 with the circuit layer 6 of the interposer, the solder bump 8 becomes a connection terminal for the connection with another stacking semiconductor device.

When such stacking semiconductor devices are stacked, as shown in Fig. 1, the semiconductor element l'of the other stacking semiconductor device is accommodated in a lower space of the interposer in the stacking semiconductor device, and the solder bumps 8 are in contact with the circuit layer of the other stacking semiconductor device.

That is, in the prior art, the respective semiconductor element is mounted onto the interposer to form one package, which is then stacked on the other to provide a large-capacity stacked type semiconductor device while ensuring the electric connection between the respective semiconductor elements.

According to the above-mentioned stacking of the packages, however, it is difficult to (1) reduce the size of the resultant semiconductor device as seen in a plan view although the increase in capacity is achievable or (2) satisfy the requirement for miniaturizing the semiconductor device even though a larger number of the packages are stacked.

Also, if the interposer is used for stacking the semiconductor elements, a high-speed response becomes difficult and this limits the use of the semiconductor device.

Therefore, recently, the stacking type semiconductor device is required to have a stack structure and/or a connection structure capable of realizing not only a large capacity, a small size and a small thickness but also a high-speed response.

### SUMMARY OF THE INVENTION

The present invention has been made in view of the above-mentioned requirements.

Accordingly, an object of the present invention is to provide a semiconductor element involving an excellent stacking structure and/or a connection structure for semiconductor elements capable of realizing a large capacity, a small size and a small thickness as well as a high- speed response, and also a semiconductor device formed by stacking such semiconductor elements.

The inventor of the present invention initially studied the prior art connection structure shown in Fig. 1 when solving the above-mentioned problems. As a result, it was noted that, if the interposer is eliminated from the prior art connection structure, it is possible to stack more semiconductor elements if the same height of the connection structure is to be maintained, or to further reduce the thickness of the semiconductor device if the same capacity of the semiconductor device is to be maintained, in addition to which, it is possible to respond to a high-speed operation so far as the interposer is eliminated. Based on this idea, the inventor diligently studied to obtain a connection structure capable of electrically interconnecting the semiconductor elements stacked to form a plurality of layers without using an interposer.

According to an aspect of the present invention, there is provided a semiconductor element comprising: an element body having a first surface and a second, opposite surface; a conductive bump formed on the first surface of the element body; and the element body having a via hole penetrating from the conductive bump on the first surface to the second surface.

An inner wall of the via hole is coated with an insulating layer and a conductive film, so that the conductive film is electrically connected to the conductive bump.

The material of the conductive film is Au or Cu. The material of the insulating layer is SiO₂.

According to another aspect of the present invention, there is provided a connection structure comprising: a first semiconductor element having a first conductive bump; a second semiconductor element comprising: an element body having a first surface and a second, opposite surface; a second conductive bump formed on the first surface of the element body; and the element body having a via hole penetrating from the conductive bump on the first surface to the second surface; and
the first and second semiconductor elements are mutually arranged in such a manner that the first conductive bump is in contact with the second surface of the second semiconductor element at a position of the vial hole; and
means for electrically connecting the first conductive bump with the second conductive bump.

According to a further aspect of the present invention, there is provided a semiconductor device comprising a plurality of semiconductor elements stacked on one another, including at least:
a first semiconductor element having a first and second, opposite surface thereof, and having a first conductive bump on the first surface;
a second semiconductor element comprising: an element body having a first surface and a second, opposite surface; a second conductive bump formed on the first surface of the element body; and the element body having a via hole penetrating from the conductive bump on the first surface to the second surface;
the first and second semiconductor elements are mutually arranged in such a manner that the first conductive bump is in contact with the second surface of the second semiconductor element at a position of the via hole; and
means for electrically connecting the first conductive bump with the second conductive bump.

According to a still further aspect of the present invention, there is provided a process for manufacturing a semiconductor element comprising the following steps of: forming a conductive bump on a first surface of a semiconductor element body; and forming a via hole which penetrates the element body from the conductive bump on the first surface to a second, opposite surface of the element body. The process further comprises the following steps of: coating an inner wall of the via hole with an insulating layer and a conductive film, so that the conductive bump is electrically connected to the conductive film.

According to still further aspect of the present invention, there is provided a process for manufacturing a semiconductor device comprising a plurality of semiconductor elements stacked on one another, the process comprising the following steps of:
preparing a plurality of semiconductor elements, the preparing step of each semiconductor element comprising: forming a conductive bump on a first surface of a semiconductor element body; forming a via hole which penetrates the element body from the conductive bump on the first surface to a second, opposite surface of the element body; and coating an inner wall of the via hole with a conductive film by means of an insulating layer so that the conductive bump is electrically connected to the conductive film.
stacking at least two semiconductor elements, one on the other, in such a manner that the conductive bump of the one semiconductor element is in contact with the second surface of another semiconductor element at a position of the via hole so that the conductive bump of the one semiconductor element is electrically connected to a conductive bump of the other semiconductor element.

### BRIEF DESCRIPTION OF THE DRAWINGS

Fig. 1 shows a prior art connection structure for semiconductor elements in the conventional stacking type semiconductor device;
Fig. 2 shows one embodiment of a semiconductor element according to the present invention;
Fig. 3 shows one embodiment of a via-hole;
Fig. 4 shows the semiconductor elements stacked according to the present invention;
Figs. 5(a) to 5(c) show the steps for producing the semiconductor element according to the present invention;
Figs. 6(a) to 6(c) show the steps for forming via-holes, insulation layers and conductive cover films in the semiconductor element;
Fig. 7 shows one embodiment of a semiconductor device stacking the semiconductor elements according to the present invention.

### DETAILED DESCRIPTION OF THE PREFERRED EMBODIMENTS

The present invention will be described below with reference to the attached drawings.

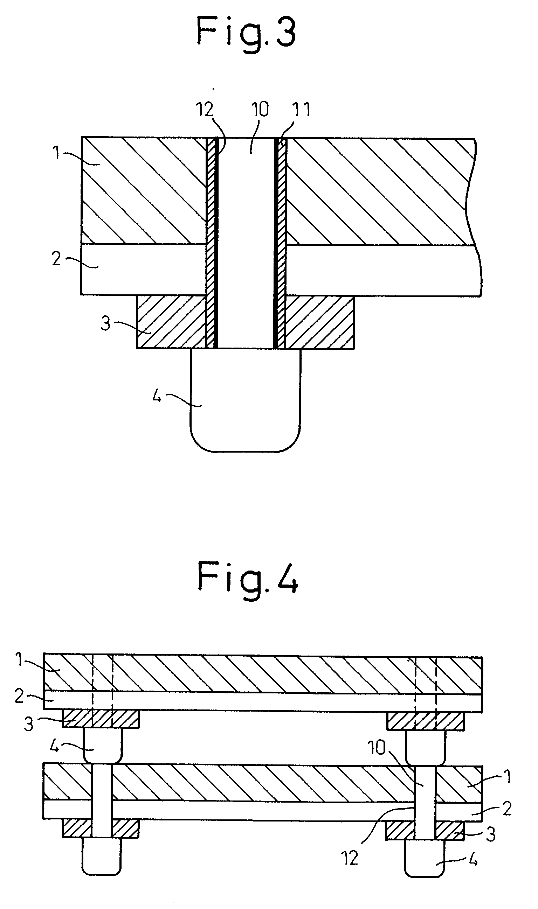

Fig. 2 shows one embodiment of a semiconductor element according to the present invention. In the semiconductor element 1 shown in Fig. 2, via-holes 10 are formed, each of which passes through a circuitry surface 2 and reaches a back surface of an Au bump (conductive bump) 4 formed on an Al pad 3. This is a first characteristic of the present invention. As shown in Fig. 3, a conductive cover film 12 is formed on the inner surface of the via-hole 10 via an insulation layer 11.

While the conductive cover film 12 is preferably made of Au or Cu, another conductive metal or alloy may be used. While the insulation layer 11 is preferably made of SiO₂ because the insulation layer and the conductive cover film can be easily formed and the insulation layer can be brought into tight contact with the conductive cover film and a wafer, another insulation material may be used provided it satisfies such requirements.

As the insulation cover film 12 is continuous with the conductive bump, it functions as a connection terminal when one semiconductor element is electrically connected to another semiconductor element.

One embodiment in which two semiconductor elements are stacked is illustrated in Fig. 4. As shown in Fig. 4, since a conductive bump 4 of the one semiconductor elements (the upper one in the drawing) abuts a via-hole 10 of the other semiconductor element (the lower one in the drawing) and is in contact with the conductive cover film 12, the conductive bumps 4 of the upper and lower conductive bumps 4 are connected to each other through the conductive cover film 12, whereby the electrical connection is directly made between the upper and lower semiconductor elements.

In such a manner, according to the present invention, it is possible to stack the semiconductor elements while ensuring the electrical connection between them without using the interposer. This is the second characteristic of the present invention.

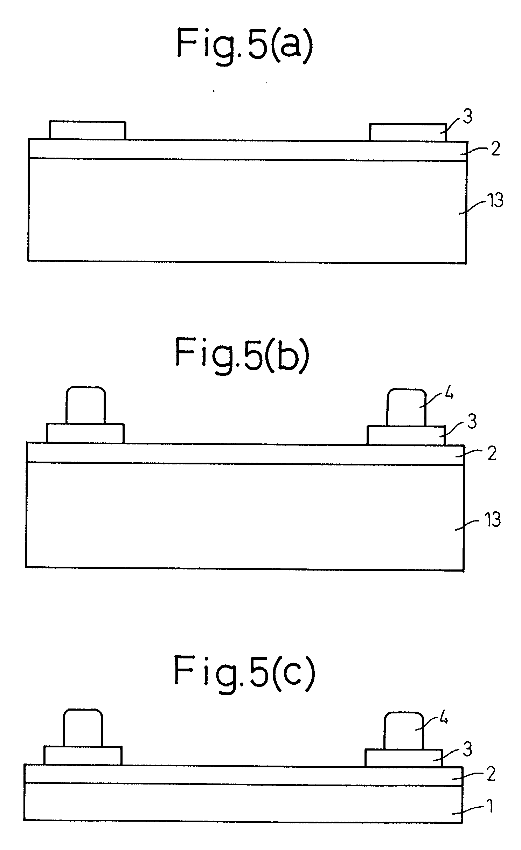

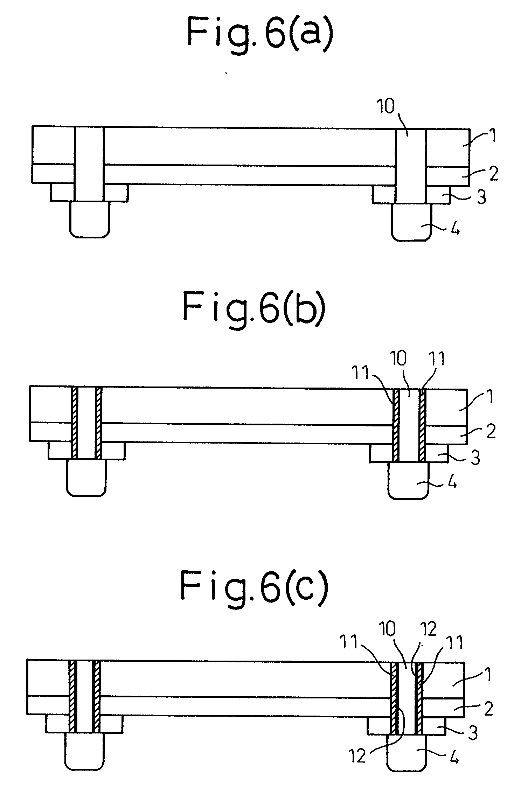

Then, a method will be described with reference to Figs. 5 and 6, for producing the semiconductor element, forming the via-holes in the semiconductor element and finally providing the conductive cover film.

On a circuitry surface 2 formed on a surface of a wafer 13 (for example, of 650 µm thick), an Al pad 3 is provided in the conventional manner (see Fig. 5(a)), and then an Au bump 4 (which is a conductive bump of about 35 µm high) is formed by using a plating or a bump bonder (see Fig. 5(b)). Thereafter, a back surface of the wafer 13 is abraded to have a desired thickness (for example, an original thickness of about 650 µm is abraded to about 50µm). Thus the semiconductor element is completed.

Next, while the Au bump 4 is turned upside down so that the Au bump 4 directs downward, a laser beam (for example, an ultraviolet laser beam) of a predetermined intensity is irradiated from above the semiconductor element 1 to a position corresponding to the Au bump to form a via-hole 10 of a proper size (for example, having a diameter of 10µm or less) passing through the semiconductor element to reach the back surface of the Au bump 4 (see Fig. 6(a)).

When the laser beam is irradiated, the Au bump 4 serves as a stopper for precisely controlling the boring process carried out by the laser beam.

Then, an insulation layer 11 is formed on the inner surface of the via-hole 10 by using CVD or a spin coater (see Fig. 6(b)). For example, by using CVD, tetraethoxysilane is vaporized to form an insulation layer of SiO₂. Thereafter, by using a plating method or a sputtering method, a conductive cover film 12 is formed on the surface of the insulation layer 11.

In this manner, a thin semiconductor element according to the present invention is produced, which is suitably used for preparing a stacking type semiconductor device.

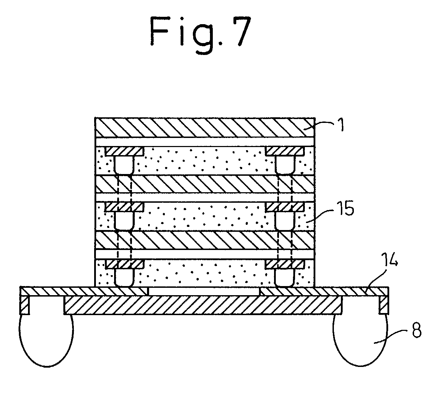

Fig. 7 illustrates one embodiment of a semiconductor device constituted by stacking the semiconductor elements according to the present invention on a circuit board 14 having solder bumps 8. The semiconductor elements are electrically connected to each other by the connection structure according to the present invention. As a resin is filled in a gap between the adjacent semiconductor elements so that an integral structure is formed, it is possible to ensure the electrical connection between the semiconductor elements and also guarantee the strength, durability, thermal resistance or others of the semiconductor device.

According to the present invention, as the semiconductor elements having the same dimension and structure are sequentially stacked to establish a direct electric connection between them, it is possible to obtain a semiconductor device large in capacity, small in size and thickness as well as responsive to a high-speed operation.

Also, according to the present invention, as the semiconductor elements having the same dimension and structure are sequentially stacked, even if the semiconductor element is heated, the thermal expansion of the respective semiconductor elements becomes approximately equal, whereby the electric connection between the semiconductor elements can be always maintained in a stable state.

It should be understood by those skilled in the art that the foregoing description relates to only some preferred embodiments of the disclosed invention, and that various changes and modifications may be made to the invention without departing the sprit and scope thereof.

## Claims

1. A semiconductor element comprising:
an element body having a first surface and a second, opposite surface;
a conductive bump formed on the first surface of the element body; and
the element body having a via hole penetrating from the conductive bump on the first surface to the second surface.

2. A semiconductor element as set forth in claim 1, wherein an inner wall of the via hole is coated with an insulating layer and also coated with a conductive film, and the conductive film is electrically connected to the conductive bump.

3. A semiconductor element as set forth in claim 2, wherein a material of the conductive film is Au or Cu.

4. A semiconductor element as set forth in claim 2, wherein a material of the insulating layer is SiO₂.

5. A connection structure comprising:
a first semiconductor element having a first conductive bump;
a second semiconductor element comprising:
an element body having a first surface and a second, opposite surface;
a second conductive bump formed on the first surface of the element body; and
the element body having a via hole penetrating from the conductive bump on the first surface to the second surface; and
the first and second semiconductor elements are mutually arranged in such a manner that the first conductive bump is in contact with the second surface of the second semiconductor element at a position of the via hole; and
means for electrically connecting the first conductive bump with the second conductive bump.

6. A connection structure as set forth in claim 5, wherein the electrically connecting means comprises a conductive film which is coated on an inner wall of the via hole of the second semiconductor element, said conduction film is coated on an insulating layer, so that the conductive film electrically connects the first conductive bump with the second conductive bump.

7. A connection structure as set forth in claim 6, wherein a material of the conductive film is Au or Cu.

8. A connection structure as set forth in claim 6, wherein a material of the insulating layer is SiO₂.

9. A semiconductor device comprising a plurality of stacked semiconductor elements, including at least:
a first semiconductor element having a first and second, opposite surface thereof, and having a first conductive bump on the first surface;
a second semiconductor element comprising:
an element body having a first surface and a second, opposite surface;
a second conductive bump formed on the first surface of the element body; and
the element body having a via hole penetrating from the conductive bump on the first surface to the second surface; and
the first and second semiconductor elements are mutually arranged in such a manner that the first conductive bump is in contact with the second surface of the second semiconductor element at a position of the vial hole; and
means for electrically connecting the first conductive bump with the second conductive bump.

10. A semiconductor device as set forth in claim 9, wherein the electrically connecting means comprises a conductive film which is coated on an inner wall of the via hole of the second semiconductor element, said conductive film is coated on an insulating layer, so that the conductive film electrically connects mutually the first conductive bump with the second conductive bump.

11. A semiconductor device as set forth in claim 10, wherein a material of the conductive film is Au or Cu.

12. A semiconductor device as set forth in claim 10, wherein a material of the insulating layer is SiO₂.

13. A process for manufacturing a semiconductor element comprising the following steps of:
forming a conductive bump on a first surface of a semiconductor element body; and
forming a via hole which penetrates the element body from the conductive bump on the first surface to a second, opposite surface of the element body.

14. A process as set forth in claim 13 further comprising the following steps of:
coating an inner wall of the via hole with a conductive film by means of an insulating layer so that the conductive bump is electrically connected to the conductive film.

15. A process for manufacturing a semiconductor device comprising a plurality of semiconductor elements stacked on one another, the process comprising the following steps of:
preparing a plurality of semiconductor elements, the preparing step of each semiconductor element comprising;
forming a conductive bump on a first surface of a semiconductor element body;
forming a via hole which penetrates the element body from the conductive bump on the first surface to a second, opposite surface of the element body; and
coating an inner wall of the via hole with an insulating layer, and a conductive film, so that the conductive bump is electrically connected to the conductive film;
stacking at least two semiconductor elements, one on the other, in such a manner that the conductive bump of the one semiconductor element is in contact with the second surface of another semiconductor element at a position.of the via hole so that the conductive bump of the one semiconductor element is electrically connected to a conductive bump of the other semiconductor element.
